# EUROPEAN PATENT SPECIFICATION

(11) **EP 2 622 115 B1**
(45) Date of publication and mention of the grant of the patent: **03.10.2018**
(21) Application number: 10857964.0
(22) Date of filing: 11.10.2010
(51) Int. Cl.: C30B 25/16, C23C 16/27, C23C 16/511, C23C 16/52, A44C 17/00, C30B 25/20, C30B 29/04, C30B 33/02, C01B 32/25

(54) **METHOD FOR GROWING WHITE COLOR DIAMONDS BY USING DIBORANE AND NITROGEN IN COMBINATION IN A MICROWAVE PLASMA CHEMICAL VAPOR DEPOSITION SYSTEM**
VERFAHREN ZUR ZÜCHTUNG WEISSER DIAMANTEN MITTELS EINER KOMBINATION VON DIBORAN UND STICKSTOFF IN EINEM MIKROWELLENPLASMA-CVD-SYSTEM
PROCÉDÉ DE CROISSANCE DE DIAMANTS DE COULEUR BLANCHE EN UTILISANT DU DIBORANE ET DE L'AZOTE EN COMBINAISON DANS UN SYSTÈME DE DÉPÔT CHIMIQUE EN PHASE GAZEUSE PAR PLASMA HYPERFRÉQUENCE

(30) Priority: 27.09.2010 SG 201007058
(43) Date of publication of application: 07.08.2013
(73) Proprietor: IIA Technologies Pte. Ltd., Singapore 048616 (SG)
(72) Inventor: MISRA, Devi Shanker, Singapore 048616 (SG)
(74) Representative: Beck Greener
(86) International application number: PCT/SG2010/000384
(87) International publication number: WO 2012/044251

(56) References cited:
- WO-A1-2009/154577
- WO-A2-2006/136929
- JP-A- H07 277 890
- US-A- 5 443 032
- US-A1- 2007 196 263

## Description

### Field of the invention

The invention relates to growing mono-crystalline white color diamonds in a microwave plasma chemical vapor deposition apparatus. In particular, the invention relates to growing white color diamonds by using diborane and nitrogen gases in combination with methane and hydrogen

### Background of the invention

The process of growing polycrystalline grains of diamond was first patented by W. G. Eversole in 1962¹. Since then, various groups and workers have deposited the Poly-crystalline²⁻⁵ as well as mono-crystalline, diamond⁶⁻⁸ using a variety of CVD techniques. Poly-crystalline diamond, in spite of having similar properties as mono-crystalline diamonds, is not a potential material for new applications due to the presence of the grain boundaries and defects⁸⁻¹⁰

For example, thermal conductivity of the poly-crystalline diamond still does not surpass thermal conductivity of natural diamond^{11,12}. Indeed, in poly-crystalline diamond, the grain boundaries inhibit exhibition of superior properties unique to diamond because the grain boundaries act as scattering centres for phonons thereby deteriorating thermal and other properties^{8,12}. The presence of large angle as well as small angle grain boundaries are a major drawback in applications of poly-crystalline diamond.

While there is a clear preference for using mono-crystalline diamonds in applications, mono-crystalline diamonds are difficult to grow with the same texture, clarity, purity and finish as natural diamond. Although, mono-crystalline diamond has superior properties compared to poly-crystalline diamond, microscopic and macroscopic graphitic and non-graphitic inclusions, feathers (long line defects) are very common in CVD grown mono-crystalline diamond. As a result, the potential of CVD grown mono-crystals of diamond to be used as a gem quality product is diminished.

Detailed characterization of defects in mono-crystalline CVD grown diamond by Raman spectroscopy and X-ray diffraction (XRD) reveals that the defects comprise graphitic regions having a size in the range of submicrometer and several micrometer in otherwise mono-crystalline diamond.

Another difficulty in growing mono crystalline CVD diamond is the low growth rates. Although the growth rates of 70-100 micrometer per hour are possible with addition of large concentration of nitrogen to CVD gases, but defects are prevalent and generally defect density increases with the growth rate.

For example, Derwent abstract of Japanese publication number JP 07277890 discloses a method for synthesizing diamond for use as semi-conductor, electronic or optical components or use in cutting tools. Specifically, the method disclosed in JP 07277890 involves growing diamond in the presence of gas containing nitrogen in a ratio of nitrogen to hydrogen of 3 to 1000 ppm or containing oxygen in a ratio of oxygen to carbon of 3 to 100% to increase growth rates.

A technical paper by Yan et. al. (PNAS, 1 October 2002, Vol. 99, no. 20, 12523-12525) discloses a method or producing mono-crystalline diamond by microwave plasma chemical vapour deposition (MPCVD) at growth rates in the range of 50 to 150 microns per hour.

The method involves a CVD process carried out at 150 torr and involves adding nitrogen to CVD gases to provide a ratio of nitrogen to methane of 1 to 5% N₂/CH₄. Yan et. al. believe that nitrogen in the stated ratio enhances growth rates because more available growth sites are created. This is believed to be a result of causing growth to change from <111> crystal planes to <100> crystal planes.

The importance of nitrogen content in CVD gases is recognised in United States patent 5,015,494 (Yamazaki) which teaches a method of growing diamond with customized properties for dedicated applications.

Yamazaki discloses forming diamond by electron cyclotron resonance CVD and discloses adding nitrogen to "prevent lattice defects from growing by virtue of external or internal stress". Nitrogen is added in a ratio of nitrogen-compound gas to carbon-compound gas of 0.1 to 5%. The resultant diamond has a nitrogen concentration of 0.01 to 1 wt%.

Additionally, Yamazaki discloses a requirement to add boron gas to the CVD gases to form boron nitride which deposits on a substrate to improve adhesion to the substrate of formed diamond.

Nitrogen, according to Yan et. al. and Yamazaki, is required for two purposes. Specifically, nitrogen is used to enhance growth rates of CVD grown mono-crystalline diamond and to prevent lattice defects in electron cyclotron resonance CVD grown mono-crystalline diamond.

### Summary of the invention

It is an object of the present invention to provide a CVD process for growing mono-crystalline diamonds of gem grade substantially free of defects and of white color.

The applicants have carried out extensive experimental work on the role that nitrogen in combination with the diborane plays in CVD processes for growing mono-crystalline diamond. The experimental work has found that using nitrogen in quantities proposed in Yan et. al. and Yamazaki results in growing diamonds that exhibit nitrogen-based defects such as micro cracks, micro inclusions etc. The diamonds such produced are of brown color and are not suitable for gem purposes. The experimental work has also found that only very small amounts of nitrogen gas in combination with the diborane, and optionally oxygen, in CVD gases will result in substantially defect-free mono-crystalline diamonds of white color and quality that are useful for gems and the amount of nitrogen and diborane determined by the applicants to be beneficial are considerably less than the nitrogen to carbon ratio disclosed in the work by Yamazaki.

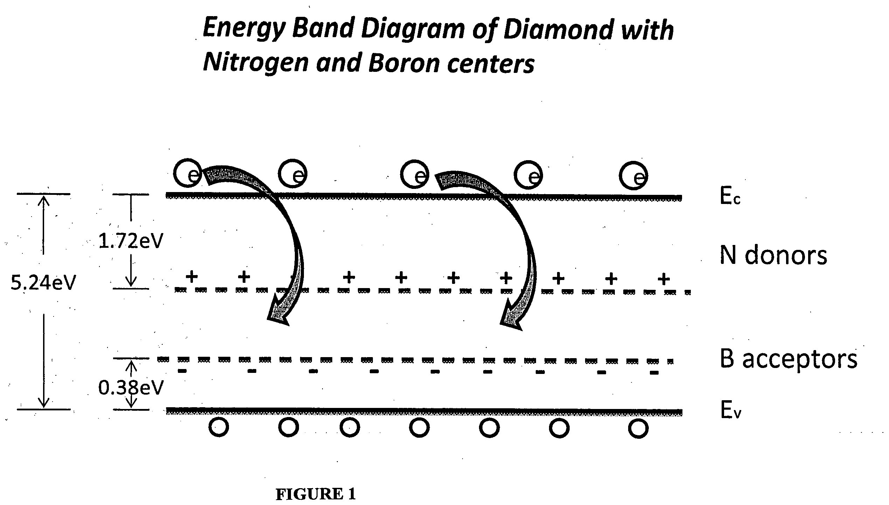

The choice of nitrogen and diborane is made as both these gases play important role in diamond growth. Nitrogen is known to incorporate in the diamond structure naturally with a number of possible defect configurations and affects the properties of natural diamond significantly. For instance, the presence of nitrogen in singly substituted configuration imparts diamond its yellowish brown color. The donor type defect centre corresponding to singly substituted nitrogen lies at about 1.8 eV in the band gap of diamond and is positively charged partially **(****FIGURE 1****).** When the white light is incident on diamond all the wavelengths below the yellow color (blue, violet and ultra violet) are absorbed and as a result the diamond appears red/brown in color.

In contrast, the presence of boron in diamond structure gives rise to a negatively charged acceptor states at 0.38 eV above the valance band as shown in **FIGURE 1****.** The blue color of the diamond originates as the holes from valance band can fill these centers which are neutralized by the electrons from the conduction band. When white light fall on the diamond doped with Boron, all the wavelengths below blue color are absorbed giving blue light out from the diamond.

Our central idea in this patent is to make white color gem grade diamond by adding very small quantities of these dopants; nitrogen and diborane gases in combination with the methane and hydrogen gases at the time of the microwave plasma chemical vapor deposition (MPCVD) process of growing diamonds to enhance the color and the clarity of the diamond mono-crystals which happens due to the compensation of the Boron and Nitrogen centers. The inventors also find that heating such diamonds upto a high temperature of 2300 °C enhances the color and clarity of diamond further thus making it of white color. Specifically, the applicants have found that CVD gases containing more than relatively small amounts of nitrogen in combination with the diborane in the gas mixture result in diamond being formed with Optical centres related to C-N and C-B-N bonds that lead to the deterioration of the color and purity of the monocrystals of diamond. Large concentrations of nitrogen in the gas mixture also lead to the micro inclusions and growth cracks in the crystals. Owing to the difference in bond length between nitrogen-carbon and carbon-carbon, and boron-carbon, the defects operate as phonon scattering centres, thereby diminishing the electrical, optical and mechanical properties of the formed mono-crystalline diamond.

The form of the inclusions is believed to be dependent on the concentration of nitrogen in the CVD gases.

Additionally, the applicants have found that, although a relatively small amount of nitrogen is required, there must be at least some nitrogen in combination with the diborane gas to be present in the CVD gases to increase the growth rate of the diamonds deposited by a CVD process. In addition, by using very small quantities of Nitrogen and in combination with the diborane, the color and the clarity of the diamond crystals can be remarkably improved. We propose that the presence of boron in the diamond structure containing nitrogen atoms will turn a yellow brown color diamond white making it a gem grade diamond.

The invention provides a method of forming single - crystalline white colour gem grade diamond by microwave plasma chemical vapour deposition, the method comprising the steps of:
(a) providing at least one diamond seed;
(b) exposing the seed to conditions for growing diamond by chemical vapour deposition, including supplying reaction gases that include a carbon-containing gas for growing diamond and include a nitrogen-diborane containing gas; and
(c) controlling the quantity of nitrogen in combination with diborane in the process so that the diamond can grow by step-growth without defects and graphitic inclusions, wherein the concentration of nitrogen used is not higher than 0.015 vol%; and
(d) heating the diamond to a temperature of 2300 °C in hydrogen plasma to enhance the color and clarity of the diamond
(d) suppress the growth of the defects and graphitic inclusions.

The quantity of nitrogen-containing gas in the reaction gases may be in the range of 0.0001 to 0.1 vol % and in combination the diborane can be present in the range of from 0.00002 to 0.05 vol %.

Hence it will be seen that by this invention applicants have found that using relatively small quantities of nitrogen in combination with diborane gas in CVD gases cause the growth of diamond to be a step-growth mechanism, in which a layer of diamond having an edge, defined by a step, grows at the edge as a front. This growth mechanism differs from a layer-growth mechanism that is typical of CVD process.

The mono crystalline diamonds grown by the step-growth mechanism with the quantities of nitrogen in combination with diborane detailed in the application are free of microscopic and macroscopic graphitic inclusions and defects that are associated with growth of diamond by layer-growth, most notably nitrogen-based inclusions.

There must be at least some nitrogen included in the CVD gases to avoid graphitic inclusions forming in the grown diamond.

Preferably, the nitrogen-containing gas is selected from any one or more of the following group: N₂ in hydrogen, N₂ in oxygen, N₂ in helium or N₂ in nitrous oxide and N₂ with diborane.

Preferably, the diborane containing gas is selected from one or more of the following group: diborane in hydrogen, diborane in argon, diborane in helium

Preferably, chemical vapour deposition conditions comprise maintaining the seed at a temperature in the range of 750 to 1200°C.

Preferably, the chemical vapour deposition conditions comprise maintaining the seed at a pressure in the range of 120 to 160 mbar.

Preferably, the carbon-containing gas comprises methane.

Preferably, the reactions gases also comprise hydrogen.

Preferably, chemical vapour deposition occurs in the presence of microwave plasma and occurs with hydrogen in the reactions gases.

Preferably, the reaction gases are in the following relative quantities: The methane 20-80 sccm (standard cubic centimetres per minute), hydrogen 300-800 sccm, nitrogen 0.0005 - 1 sccm, diborane 0.0001 - 0.5 sccm, oxygen 1-10 sccm. The invention also provides a mono-crystalline diamond of gem quality formed in accordance with the method of the invention.

Preferably, the method is characterised by producing gem quality diamonds.

Preferably the seed should be oriented (100) crystalline orientation.

The diamond grown on the seed up to a thickness of 2 mm is not oriented exactly in (100) crystalline orientation but it loses the orientation and other crystalline orientations are also present.

We have checked the crystalline orientation of the diamonds grown up to a thickness > 2 mm and find that other crystalline orientations can also be present in small quantity.

### Brief description of the drawings

A preferred embodiment of the invention will now be described, by way of example only, with reference to the accompanying drawings, in which:
**FIGURE 1** is the Energy-band diagram of the CVD diamond showing the position of Nitrogen, donor levels, and Boron acceptor levels in the band gap. These donors and acceptors levels may be partly charged.
**FIGURE 2** is a flow chart of the deposition process in which the Nitrogen (0.015 vol %) and Diborane (0.005 vol %) are used in optimal quantities in the gas mixture.
**FIGURE 3** is the flow chart of the process when only Nitrogen flow is used in the gas mixture.
**FIGURE 4** is the flow chart of the process where Nitrogen and Diborane are not used and diamond is grown with only using Methane and Hydrogen in the gas mixture.
**Figure 5** is an FTIR spectrum of diamond deposited in a CVD process utilising Nitrogen in the CVD gases in the range of 0.02 to 0.1 % in combination with Diborane in the range 0.01 to 0.05 %. The IR peaks relating to C-B-N centres can be seen showing the incorporation of N and B in the samples.

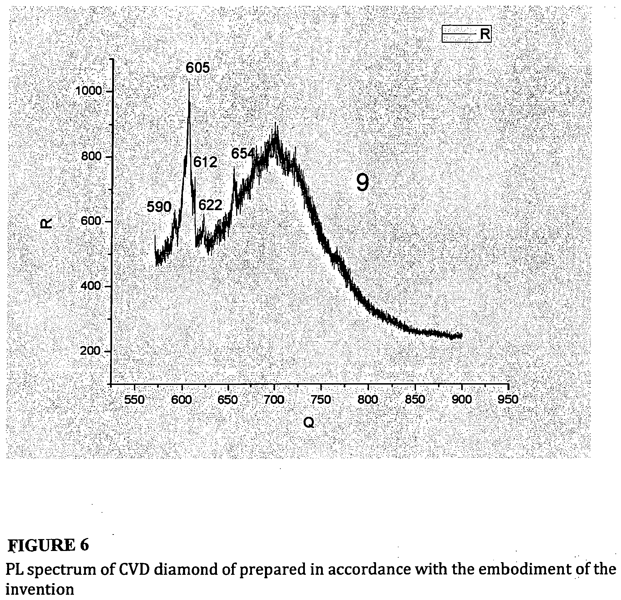

**Figure 6** is a photoluminescence spectrum of diamond deposited in a CVD process in accordance with the invention and utilising Nitrogen in the CVD gases in the range of 0.0001 to 0.02 vol % in combination with the Diborane flow in the mixture of 0.00005 to 0.005 %. The PL spectrum shows that the diamonds deposited using Nitrogen in combination with Diborane with the specified volume % have a strong peak at 605 nm and a broad band of low intensity at 700 nm. The peak at 605 nm is an indication of the good quality of the samples.
   In contrast the PL spectrum of the diamonds grown utilizing only Nitrogen flow in the range of 0.0001 %-0.02 % without Diborane show no peak at 605 nm and a high intensity broad band at 700 nm (**FIGURE 7**) indicating the presence of the impurities in the diamonds.

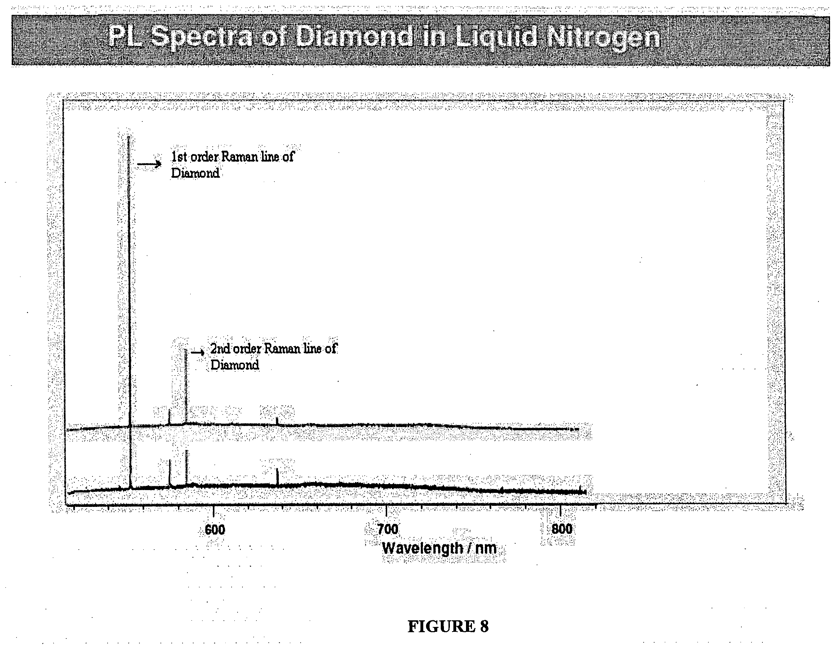

**FIGURE 8** is a Raman spectrum of the samples grown in our procees. A strong intense line at 1332 cm⁻¹ shows the excellent quality of the diamonds grown in our process.
**FIGURES 9** is the optical microscope images at high magnifications of the diamonds grown in a CVD process including 0.015 % Nitrogen and 0.005 % Diborane in accordance with the invention and showing step-growth of diamond
**Figure 10** shows optical microscope images at high magnifications of the diamonds grown in a CVD process including 0.02 % Nitrogen without Diborane and showing step-growth of diamond. However the steps are not clean and straight but uneven with defects.

### Detailed description of an embodiment

A method of growing mono-crystalline diamond in accordance with the invention involves a CVD process that utilises microwave plasma.

Diamond is grown on a substrate comprising a diamond seed that may vary in size between 3 x 3mm and 5 x 5mm. The method is carried out in a microwave plasma chamber.

The crystallographic orientation of the seeds is determined and seeds having an orientation other than (100) are rejected. Seeds having an orientation of (100) are polished to optical finish with roughness of the order of the wavelength of visible light in preparation for the CVD process.

Once the seeds are located in the chamber, the temperature inside the chamber is increased from ambient temperature to a temperature in the range of 750 to 1200°C and the pressure inside the chamber is reduced to a pressure in the range of 120 to 160 mbar.

The chamber is supplied with gases for growing diamond and the gases comprise methane (CH₄), hydrogen (H₂), nitrogen (N₂) in combination with diborane, and helium (He) and are passed through the chamber at a gas flow rate of 30 l/hr.

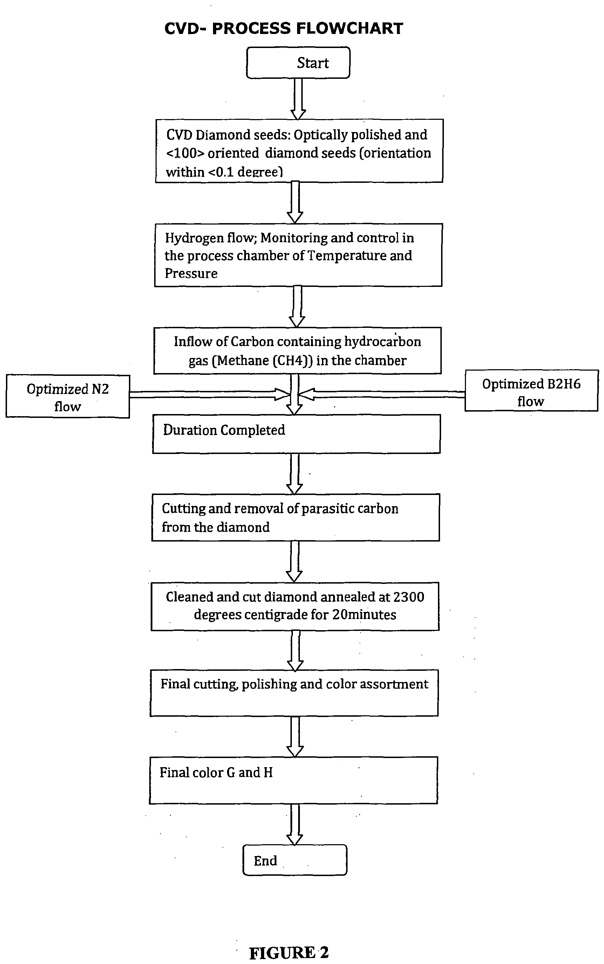

Nitrogen in combination with the Diborane gas are supplied in a quantity that comprises 0.0001 to 0.1 vol % of the balanced gases for growing diamond. For the optimal % use of the Nitrogen and Diborane (**FIGURE 2**), the growth rate of the diamond is about 18-20 micrometer per hour.

An electrical field is applied to surround the seeds such that plasma is generated from the gases in the chamber. The electrical field is generated by a magnetron operating at 6000 Watt and at 2.45 GHz. The generated electrical field causes the hydrogen gas to ionise, thereby forming plasma in the vicinity of the diamond seeds. Under these process conditions, diamond is caused to grow on the diamond seeds.

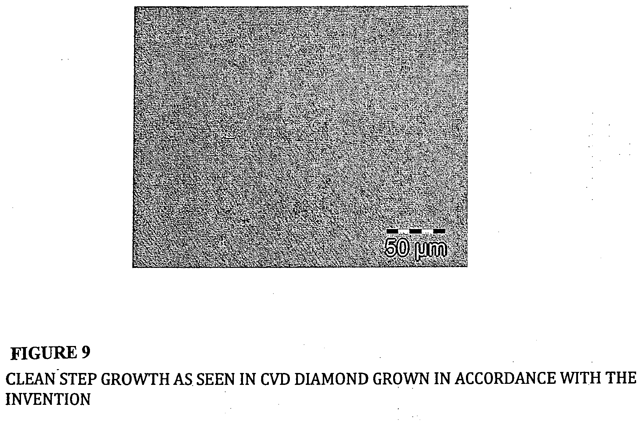

The growth pattern of diamond, as shown in **FIGURE 9****,** is step-wise and therefore enables diamond to grow that is substantially defect and impurity free.

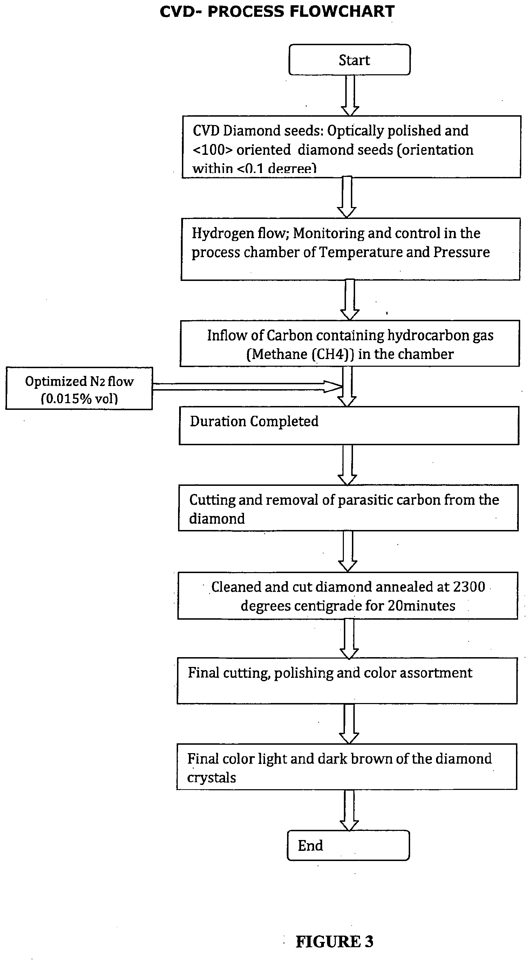

By way of comparison, the same process conditions were used with the supply of Nitrogen being altered to comprise 0.005 to 0.02 vol % without diborane, **(****FIGURE 3****).** The resultant diamond crystals are of light brown and dark brown color.

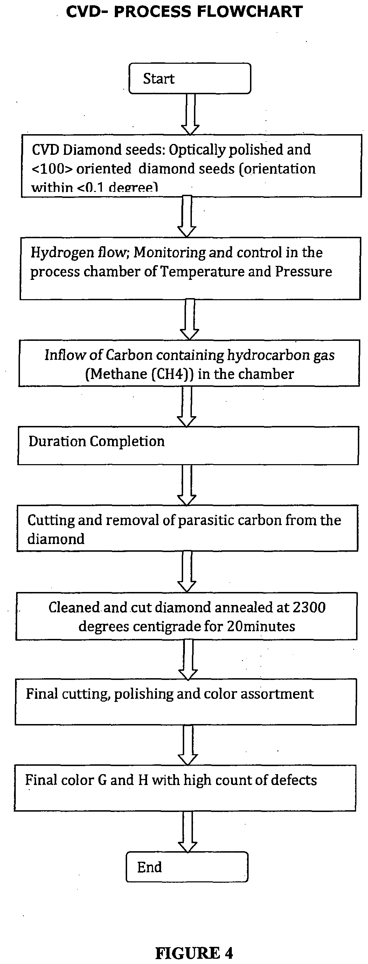

When no Nitrogen and Diborane combination were used as shown in **FIGURE 4** the diamond crystals resulted in white color but with substantial degree of the defects.

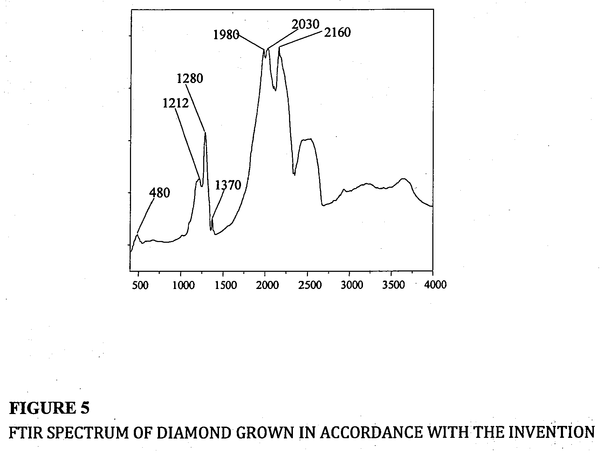

FTIR analysis of samples is used to determine the concentration and bonding of nitrogen and boron in samples. The FTIR spectra of samples grown in accordance with the invention and in accordance with the altered nitrogen supply are shown in **FIGURE 5****.**

The FTIR spectra (**FIGURE 5**) of the diamond samples grown with Nitrogen in the gas mixture in the range of 0.02 to 0.1 % in combination with Diborane in the range 0.01 to 0.05 % show clear and strong signatures of the boron-nitrogen centres in the samples along with some typical nitrogen centres. Specifically, intense bands related to boron-nitrogen centres are evident at 1370 cm⁻¹. The bands at 1210 and 1280 cm⁻¹ might belong to nitrogen centres along with the C-C bands at 1978 cm⁻¹, 2026 cm⁻¹ and 2160 cm⁻¹. The nitrogen centres in the diamond samples may exist in many configurations detailed below.

### • Single atom substitution:

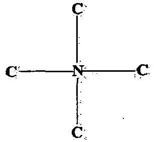

The characteristics peaks in FTIR spectra exist at 1130 and 1350 cm⁻¹ and EPR gives a "g" value of 2.0024 for this centre. This centre appears as a weak signature in the samples around 1100 cm⁻¹ in the samples grown with nitrogen in the range of 0.005 to 0.02 %.

### • "A" aggregate:

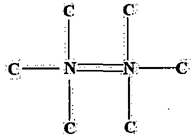

480-490 cm⁻¹ and 1282 cm⁻¹ are the characteristic peaks of A-aggregate in FTIR. These peaks are evident in Figure 2 for samples produced with concentrations of nitrogen much greater than for the invention. The A aggregates are also present in natural diamond samples in large concentration which was used as a substrates in the present case.

### • "B" aggregate:

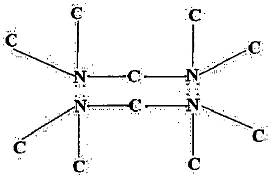

B-aggregate in diamond is believed to consist of 4 / 8 nitrogen atoms in pair with carbon atoms. These peaks are evident in natural diamonds mostly and may not be present in samples of the present invention.

### • N3 Centre:

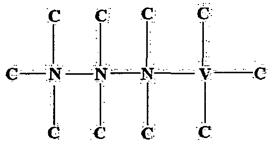

N3 centre is not FTIR active and, accordingly, does not appear in Figures 1 and 2. However, N3 centres show a sharp band at 415 nm in photoluminescence (PL) and UV spectroscopy. This centre consists of three nitrogen atom surrounding a vacancy (V).

### • Platelets:

Platelets consist of one or two extra atomic layers inserted in the diamond lattice. The nature of the platelets is still be analyzed in detail in diamond lattice. However, the fact that the corresponding IR band is observed only in diamonds containing an appreciable amount of nitrogen suggests that platelet contain nitrogen, and probably consist either partly or entirely of nitrogen. The position of the platelet peak varied from 1354-1384 cm⁻¹ from sample to sample. This variation of position is attributed to the susceptibility of the platelets to strain induced into the crystal by the A and B-aggregates defects. The presence of the platelet absorption indicates A-aggregates start to diffuse to form B-aggregates. The platelet peak position is inversely correlated to platelet size.

From the results described above we can conclude that in the samples grown with the flow rates of nitrogen in the range 0.005 to 0.02 % the nitrogen is present in the form of single substitution and small concentration of A-aggregates.

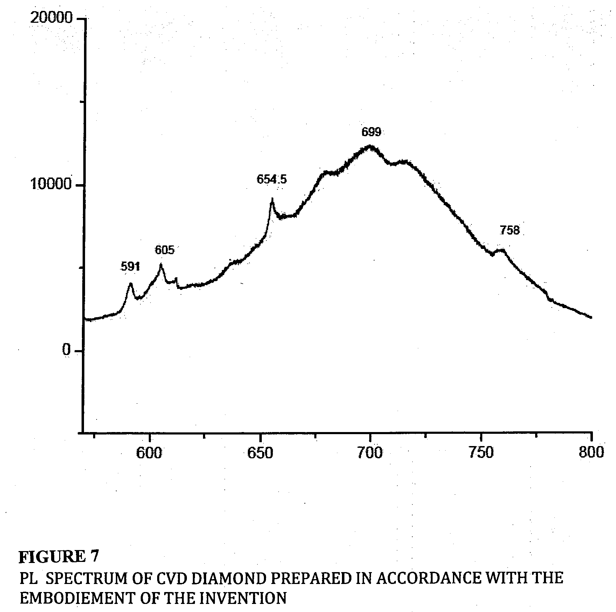

Photoluminescence spectroscopy was performed on samples produced with a nitrogen gas flow of 0.0001 to 0.02 vol % in combination with the diborane flow in the mixture of 0.00005 to 0.005 %. The results are shown in FIGURE F and show intense peaks at 605 nm (2.05 eV) and a low intensity broad band around 700 nm. The broad band is assigned to the impurities that degrade the quality of gem grade diamond. In contrast the PL spectra of the diamonds prepared using only Nitrogen flow in the range of 0.0001 % - 0.02 % without Diborane show no peak at 605 nm and a high intensity broad band at 700 nm (FIGURE 7).

Samples of diamonds are heated further post deposition to a temperature of 2300 °C to form the complexes of boron and nitrogen to enhance the color and clarity of the diamonds significantly.

No boron centre is visible in PL spectra as it is possible that boron compensates nitrogen increasing the optical clarity and purity of the diamond single crystals.

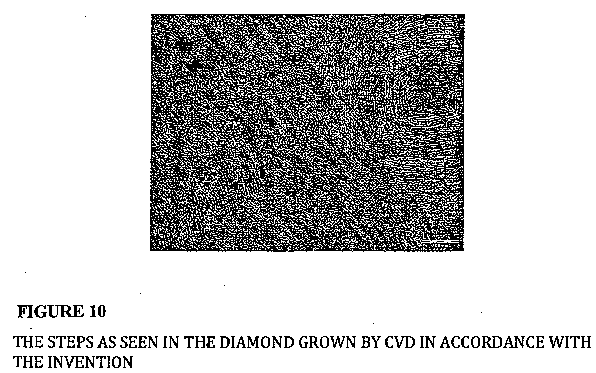

Optical microscopy images of the samples grown at Nitrogen concentrations in combination with Diborane in the range according to the invention are shown in images in **FIGURES 9** **and** **10****.** The images are taken in the range of magnification 500-5000 and the step-wise growth of diamond is evident from the surface of diamond shown in the images.

A high density of the growth steps on the surface of a sample grown with nitrogen flow in accordance with the invention is also evident in **FIGURE 9****.** These growth steps are present due to the screw dislocation observed in the crystal growth process of a number of materials and are a clear signature that the diamond in accordance with the invention system grows with the help of dislocations and with a step growth mechanism.

In contrast, CVD diamond grown in the gas using optimal quantity of Nitrogen in combination with Diborane flow, in accordance with the invention, depicts regular equidistant steps and is substantially free of graphitic inclusions.

A concentration of Nitrogen higher than 0.015 vol % in the gas phase results in microscopic and macroscopic graphitic inclusions **(****FIGURE 10****).** Such inclusions and defects form on the steps and adversely affect the properties of the formed diamond.

The step-growth mechanism in the nitrogen concentration regime specified in the invention appears to be advantageous because it is less susceptible to incorporating defects and inclusions in the formed diamond, with the result that formed diamond is substantially free of defects and inclusions. Such formed diamond is gem quality and has superior electrical, optical and mechanical properties compared to other forms of diamond grown by CVD and properties that approach the properties of natural diamond.

Reference to any prior art in the specification is not, and should not be taken as, an acknowledgment or any form of suggestion that this prior art forms part of the common general knowledge in Australia or any other country.

It will be understood that the term "comprises" or its grammatical variants as used in this specification and claims is equivalent to the term "includes" and is not to be taken as excluding the presence of other features or elements.

### References:

1. W. G. Eversole U S Patent 3030187, 3030187 (1962) For a good review of the various techniques please refer to the following:
2. S. Matsumoto, Y. sato, M. kamo, and N. Setaka, Jpn. J. Appl. Phys. 21, L183, (1982).
3. J. E. Filed Properties of Diamond (Academic Press, London 1992).
4. R. E. Clausing, L. L> Horton, J. C. Angus and P. Koidl, Diamond and Diamond like films and coating (Plenum press, New York, 1991).
5. J. C. Angus Thin solid Films, 216, 126 (1992).
6. F. Silva, J. Achard, X. Bonnin, O. Brinza, A. Michau, A. Secroun, K. De Corte, S. Felton, M. Newton, A. Gicquel, Diamond and Related Materials, 17, 1067, (2008).
7. Yafei Zhang, Chuanyi Zang, Hongan Ma, Zhongzhu Liang, Lin Zhou, Shangsheng Li, Xiaopeng Jia, Diamond and Related Materials, 17, 209, (2008).
8. Qi Liang, Chih-shiue Yan, Yufei Meng, Joseph Lai, Szczesny Krasnicki, Ho-kwang Mao, Russell J. Hemley, Diamond and Related Materials, 18, 698, (2009).
9. J. S. Kim, M. H. Kim, S. S. Park, and Y. J. Lee, J. Appl. Phys., 67, 3354 (1990).
10. A. M. Bonnot Phys. Rev. B 41, 6040 (1990).
11. United States patent application no. 5540904 (1995).
12. Y. Yamamoto, T. Imai, K. Tanabe, T. Tsuno, Y. Kumazawa, N. Fujimori Diamond and Related Materials, 6, 1057, (1997).
13. International patent application WO 2009/154577 A1.

## Claims

1. A method of forming mono-crystalline white colour gem grade diamond by microwave plasma chemical vapour deposition, the method comprising the steps of:
(a) providing at least one diamond seed;
(b) exposing the diamond seed to conditions for growing gem grade diamond by microwave plasma chemical vapour deposition, including supplying reaction gases that include a carbon-containing gas for growing diamond and include a nitrogen-containing gas and diborane;
(c) controlling the quantity of nitrogen-containing gas and diborane relative to other gases in the reaction gases such that diamond is caused to grow by step-growth without defects and graphitic inclusions, wherein the concentration of nitrogen used is not higher than 0.015 vol%; and
(d) heating the diamond to a temperature of 2300 °C in hydrogen plasma to enhance the colour and clarity of the diamond.

2. A method of forming mono-crystalline white colour gem grade diamond as in Claim 1 wherein the quantity of nitrogen-containing gas in the reaction gases is in the range of 0.0001 to 0.1 vol %.

3. A method of forming gem grade white colour mono-crystalline diamond as in Claim 1 wherein the diborane is present in the range of from 0.00002 to 0.05 vol %.

4. A method of forming gem grade white colour mono-crystalline diamond as in Claim 1 wherein the nitrogen-containing gas is selected from any one or more of the group comprising nitrogen in hydrogen, nitrogen in oxygen, nitrogen in helium, nitrogen in nitrous oxide or nitrogen with diborane.

5. A method of forming mono-crystalline white colour gem grade diamond as in Claim 1 wherein the microwave plasma chemical vapour deposition comprises maintaining the diamond seed at a temperature in the range of 750 to 1200 °C.

6. A method of forming mono-crystalline white colour gem grade diamond as in Claim 1 wherein the microwave plasma chemical vapour deposition comprises maintaining the diamond seed at a pressure in the range of 120 to 160 mbar.

7. A method of forming mono-crystalline white colour gem grade diamond as in Claim 1 wherein the carbon-containing gas comprises methane.

8. A method of forming mono-crystalline white colour gem grade diamond as in Claim 1 wherein the reaction gases further comprise hydrogen.

9. A method of forming mono-crystalline white colour gem grade diamond as in Claim 1 wherein the microwave plasma chemical vapour deposition occurs in the presence of hydrogen in the reaction gases.

10. A method of forming mono-crystalline white colour gem grade diamond as in Claim 9 wherein the microwave plasma is generated by a magnetron operating at 6000 Watt and at 2.45 GHz.

11. A method of forming mono-crystalline white colour gem grade diamond as in Claim 1 wherein the reaction gases are passed through a reaction chamber at a gas flow rate approximately 30 l/hr.

12. A method of forming mono-crystalline white colour gem grade diamond as in Claim 1 wherein the diamond seed is oriented in the (100) crystalline orientation.

13. A method of forming mono-crystalline white colour gem grade diamond as in Claim 1 wherein the diamond seed is a size between 3 x 3 mm and 5 x 5 mm.

## Patentansprüche

1. Verfahren zum Bilden eines monokristallinen weißen Diamanten in Edelsteinqualität durch eine chemische Gasphasenabscheidung mit Mikrowellenplasma, wobei das Verfahren die folgenden Schritte umfasst:
(a) Bereitstellen von mindestens einem Diamantkeim;
(b) Exponieren des Diamantkeims gegenüber Bedingungen zum Züchten eines Diamanten in Edelsteinqualität durch eine chemische Gasphasenabscheidung mit Mikrowellenplasma, einschließend das Zuführen von Reaktionsgasen, die ein kohlenstoffhaltiges Gas zum Züchten eines Diamanten einschließen und ein stickstoffhaltiges Gas und Diboran einschließen;
(c) Steuern der Menge an stickstoffhaltigem Gas und Diboran in Bezug auf andere Gase in den Reaktionsgasen, sodass veranlasst wird, dass der Diamant durch ein Stufenwachstum ohne Defekte und Grafiteinschlüsse wächst, wobei die Konzentration des verwendeten Stickstoffs nicht höher ist als 0,015 Vol.-%; und
(d) Erwärmen des Diamanten auf eine Temperatur von 2300 °C in Wasserstoffplasma, um die Farbe und Reinheit des Diamanten zu verbessern.

2. Verfahren zum Bilden eines monokristallinen weißen Diamanten in Edelsteinqualität nach Anspruch 1, wobei die Menge an stickstoffhaltigem Gas in den Reaktionsgasen im Bereich von 0,0001 bis 0,1 Vol.-% liegt.

3. Verfahren zum Bilden eines weißen monokristallinen Diamanten in Edelsteinqualität nach Anspruch 1, wobei das Diboran im Bereich von 0,00002 bis 0,05 Vol.-% vorliegt.

4. Verfahren zum Bilden eines weißen monokristallinen Diamanten in Edelsteinqualität nach Anspruch 1, wobei das stickstoffhaltige Gas aus einem beliebigen oder mehreren der Gruppe, umfassend Stickstoff in Wasserstoff, Stickstoff in Sauerstoff, Stickstoff in Helium, Stickstoff in Stickoxid oder Stickstoff mit Diboran, ausgewählt ist.

5. Verfahren zum Bilden eines monokristallinen weißen Diamanten in Edelsteinqualität nach Anspruch 1, wobei die chemische Gasphasenabscheidung mit Mikrowellenplasma das Halten des Diamantkeims bei einer Temperatur in dem Bereich von 750 bis 1200 °C umfasst.

6. Verfahren zum Bilden eines monokristallinen weißen Diamanten in Edelsteinqualität nach Anspruch 1, wobei die chemische Gasphasenabscheidung mit Mikrowellenplasma das Halten des Diamantkeims bei einem Druck in dem Bereich von 120 bis 160 mbar umfasst.

7. Verfahren zum Bilden eines monokristallinen weißen Diamanten in Edelsteinqualität nach Anspruch 1, wobei das kohlenstoffhaltige Gas Methan umfasst.

8. Verfahren zum Bilden eines monokristallinen weißen Diamanten in Edelsteinqualität nach Anspruch 1, wobei die Reaktionsgase ferner Wasserstoff umfassen.

9. Verfahren zum Bilden eines monokristallinen weißen Diamanten in Edelsteinqualität nach Anspruch 1, wobei die chemische Gasphasenabscheidung mit Mikrowellenplasma in Gegenwart von Wasserstoff in den Reaktionsgasen stattfindet.

10. Verfahren zum Bilden eines monokristallinen weißen Diamanten in Edelsteinqualität nach Anspruch 9, wobei das Mikrowellenplasma durch ein Magnetron erzeugt wird, das bei 6000 Watt und bei 2,45 GHz betrieben wird.

11. Verfahren zum Bilden eines monokristallinen weißen Diamanten in Edelsteinqualität nach Anspruch 1, wobei die Reaktionsgase mit einer Gasdurchflussrate von annähernd 30 l/h durch eine Reaktionskammer geleitet werden.

12. Verfahren zum Bilden eines monokristallinen weißen Diamanten in Edelsteinqualität nach Anspruch 1, wobei der Diamantkeim in der kristallinen Ausrichtung (100) ausgerichtet ist.

13. Verfahren zum Bilden eines monokristallinen weißen Diamanten in Edelsteinqualität nach Anspruch 1, wobei der Diamantkeim einer Größe zwischen 3x3 mm und 5x5 mm entspricht.

## Revendications

1. Procédé de formation d'un diamant monocristallin de qualité gemme et de couleur blanche par dépôt chimique en phase vapeur de plasma par micro-ondes, le procédé comprenant les étapes consistant à :
(a) fournir au moins un germe de diamant ;
(b) exposer le germe de diamant à des conditions permettant la croissance du diamant de qualité gemme par dépôt chimique en phase vapeur de plasma par micro-ondes, comprenant la fourniture de gaz de réaction qui incluent un gaz contenant du carbone pour la croissance du diamant et incluent un gaz contenant de l'azote et du diborane ;
(c) contrôler la quantité de gaz contenant de l'azote et de diborane par rapport aux autres gaz dans les gaz de réaction de manière à causer la croissance du diamant pas à pas sans défauts ni inclusions graphitiques, la concentration d'azote utilisée n'étant pas supérieure à 0,015 % en volume ; et
(d) chauffer le diamant à une température de 2300 °C dans du plasma d'hydrogène pour renforcer la couleur et la clarté du diamant.

2. Procédé de formation d'un diamant monocristallin de qualité gemme et de couleur blanche comme dans la revendication 1, dans lequel la quantité de gaz contenant de l'azote dans les gaz de réaction est dans la gamme de 0,0001 à 0,1 % en volume.

3. Procédé de formation d'un diamant monocristallin de couleur blanche et de qualité gemme comme dans la revendication 1, dans lequel le diborane est présent dans la gamme de 0,00002 à 0,05 % en volume.

4. Procédé de formation d'un diamant monocristallin de couleur blanche et de qualité gemme comme dans la revendication 1, dans le quel le gaz contenant de l'azote est sélectionné entre un ou plusieurs éléments du groupe comprenant : azote dans l'hydrogène, azote dans l'oxygène, azote dans l'hélium, azote dans l'oxyde nitreux et azote avec diborane.

5. Procédé de formation d'un diamant monocristallin de couleur blanche et de qualité gemme comme dans la revendication 1, dans lequel le dépôt chimique en phase vapeur de plasma par micro-ondes comprend le maintien du germe de diamant à une température dans le gamme de 750 à 1200 °C.

6. Procédé de formation d'un diamant monocristallin de couleur blanche et de qualité gemme comme dans la revendication 1, dans lequel le dépôt chimique en phase vapeur de plasma par micro-ondes comprend le maintien du germe de diamant à une pression dans la gamme de 120 à 160 mbar.

7. Procédé de formation d'un diamant monocristallin de couleur blanche et de qualité gemme comme dans la revendication 1, dans lequel le gaz contenant du carbone comprend le méthane.

8. Procédé de formation d'un diamant monocristallin de couleur blanche et de qualité gemme comme dans la revendication 1, dans lequel les gaz de réaction comprennent en outre l'hydrogène.

9. Procédé de formation d'un diamant monocristallin de couleur blanche et de qualité gemme comme dans la revendication 1, dans lequel le dépôt chimique en phase vapeur de plasma par micro-ondes a lieu en présence d'hydrogène dans les gaz de réaction.

10. Procédé de formation d'un diamant monocristallin de couleur blanche et de qualité gemme comme dans la revendication 9, dans lequel le plasma par micro-ondes est généré par un magnétron fonctionnant à 6000 W et à 2,45 GHz.

11. Procédé de formation d'un diamant monocristallin de couleur blanche et de qualité gemme comme dans la revendication 1, dans lequel les gaz de réaction passent par une chambre de réaction à un débit de gaz d'environ 30 l/h.

12. Procédé de formation d'un diamant monocristallin de couleur blanche et de qualité gemme comme dans la revendication 1, dans lequel le germe de diamant est orienté suivant l'orientation cristallographique (100).

13. Procédé de formation d'un diamant monocristallin de couleur blanche et de qualité gemme comme dans la revendication 1, dans lequel le germe de diamant est d'une taille entre 3x3 mm et 5x5 mm.
